# EUROPÄISCHE PATENTSCHRIFT

(11) **EP 3 219 445 B1**
(45) Veröffentlichungstag und Bekanntmachung des Hinweises auf die Patenterteilung: **04.12.2019**
(21) Anmeldenummer: 17000371.9
(22) Anmeldetag: 07.03.2017
(51) Int. Cl.: B25F 5/02, H01R 12/57, H02P 3/06, H05K 5/02, H05K 7/14, B25F 5/00

(54) **ELEKTROMECHANISCHE FUNKTIONSEINHEIT FÜR EIN AKKUBETRIEBENES, HANDGEFÜHRTES ARBEITSGERÄT**
ELECTROMECHANICAL FUNCTIONAL UNIT FOR A BATTERY OPERATED, HAND-HELD WORK DEVICE
UNITÉ FONCTIONNELLE ÉLECTROMÉCANIQUE POUR UN APPAREIL DE TRAVAIL MANUEL ALIMENTÉS PAR BATTERIES

(30) Priorität: 16.03.2016 DE 102016003151
(43) Veröffentlichungstag der Anmeldung: 20.09.2017
(73) Patentinhaber: Andreas Stihl AG & Co. KG, 71336 Waiblingen (DE)
(72) Erfinder: Gurr, Kay-Steffen, D-74078 Heilbronn (DE); Kolb, Joachim, D-71638 Ludwigsburg (DE); Liebhard, Gernot, D-71332 Waiblingen (DE); Müller, Matthias, D-73614 Schorndorf (DE)
(74) Vertreter: Wasmuth, Rolf

(56) Entgegenhaltungen:
- EP-A1- 1 903 588
- EP-A2- 2 524 773
- EP-A2- 2 929 986
- WO-A1-2014/013474

## Beschreibung

Die Erfindung betrifft eine elektromechanische Funktionseinheit für ein akkubetriebenes, handgeführtes Arbeitsgerät mit einem Betriebsschalter zur Inbetriebnahme des Arbeitsgerätes. Der Betriebsschalter ist von einem Betätigungsglied des Arbeitsgerätes zu betätigen, wobei bei geschlossenem Betriebsschalter über eine Steuereinheit das Arbeitsgerät in Betrieb genommen wird. Die Steuereinheit umfasst eine Platine mit elektronischen Bauelementen, wobei die Platine der Steuereinheit eine erste Platinenseite und eine von der ersten Platinenseite abgewandte zweite Platinenseite aufweist.

Elektrische Arbeitsgeräte, insbesondere akkubetriebene Arbeitsgeräte wie Heckenscheren, Motorsägen, Freischneider, Blasgeräte oder dgl. benötigen einen als elektrischen Schalter ausgebildeten Betriebsschalter zur Inbetriebnahme des Arbeitsgerätes. Dieser elektrische Schalter wird meist nahe einem Betätigungsglied des Arbeitsgerätes angeordnet, um in einfacher Weise den Einschaltpunkt des Schalters mit dem Betätigungshub des Betätigungsgliedes abstimmen zu können.

Ein in der Nähe eines Betätigungsgliedes des Arbeitsgerätes angeordneter Betriebsschalter bedingt eine elektrische Verdrahtung zum Akkupack und der Steuereinheit. Der Anschluss der Verdrahtung erfolgt meist mittels Kabelschuhen, die aufgrund von Lockerung, Oxidation oder dgl. Einflüssen Fehlerquellen darstellen können.

Wird der Betriebsschalter mit größerem Abstand von einem Betätigungsglied angeordnet, so sind Hebelanordnungen oder dgl. Wirkverbindungen zur mechanischen Betätigung des Betriebsschalters notwendig. Dabei ist darauf zu achten, die zwangsweise vorhandene Toleranzkette klein zu halten, damit einer vorgegebenen Hubstellung des Betätigungsgliedes ein reproduzierbarer Einschaltpunkt des Betriebsschalters zugeordnet ist.

Aus der EP 1 903 588 A1 ist ein Funktionsmodul für ein Akkuwerkzeug bekannt, bei welchem das Modulgehäuse einen Betriebsschalter hält. Der Betriebsschalter weist Schiebekontakte auf, die auf der Platine gehalten und geführt sind. Auf den Betriebsschalter einwirkende Kräfte werden auf die Platine übertragen.

Die EP 2 524 773 A2 zeigt ein Funktionsmodul mit einem Betriebsschalter für ein elektrisches Arbeitswerkzeug, wobei die Kontaktzungen des Betriebsschalters auf der Platine ausgebildet sind.

Der Erfindung liegt die Aufgabe zugrunde, eine elektromechanische Funktionseinheit für ein akkubetriebenes, handgeführtes Arbeitsgerät bereitzustellen, welches einerseits einen geringen Verdrahtungsaufwand im Arbeitsgerät benötigt und andererseits eine präzise Abstimmung des Einschaltpunktes des Betriebsschalters mit einem Betätigungsglied ermöglicht.

Die Aufgabe wird erfindungsgemäß nach den Merkmalen des Anspruchs 1 gelöst.

Wird der Betriebsschalter unmittelbar auf der Platine der Steuereinheit angeordnet, können der Verdrahtungsaufwand reduziert und Verbindungen über Kabelschuhe vermieden werden. Der auf einer zweiten Platinenseite eingelötete Betriebsschalter wird unabhängig von der Platine selbst über eine Stützvorrichtung statisch abgestützt, wobei die Stützvorrichtung ohne mechanische Verbindung zur Platine von der zweiten Platinenseite zur ersten Platinenseite führt. Die Lage des Betriebsschalters ist somit nicht durch seine Lage auf der Platine selbst bestimmt, sondern ausschließlich über die Stützvorrichtung. Die Montagelage des Betriebsschalters auf der Platine der Steuereinheit kann ungenau sein; auch kann die Lage der Platine im Arbeitsgerät selbst fehlerbehaftet sein. Da der Betriebsschalter über eine von der Platine unabhängige Stützvorrichtung gehäusefest abgestützt ist, geht eine toleranzbehaftete Lage des Betriebsschalters auf der Platine ebenso wenig in die Toleranzkette ein wie eine fehlerhafte Lage der Platine im Gehäuse des Arbeitsgerätes.

Erfindungsgemäß ist die Stützvorrichtung derart ausgebildet, dass sie eine Durchgangsöffnung der Platine durchragt. Dadurch kann die Platine von der Stützvorrichtung freigestellt werden, so dass Wechselwirkungen zwischen der Stützvorrichtung und der Platine vermieden sind.

Vorteilhaft ist die Platine in einer Aufnahmewanne gehalten, wobei die erste Platinenseite der Aufnahmewanne zugewandt liegt. Die Stützvorrichtung ist derart vorgesehen, dass sie den Betriebsschalter gegen die Aufnahmewanne abstützt, insbesondere gegen den Boden der Aufnahmewanne abstützt.

Ist die Platine in der Aufnahmewanne positioniert und liegt der Betriebsschalter an der Stützvorrichtung an, wird die Platine in der Aufnahmewanne fixiert, insbesondere vergossen. Ein partielles Vergießen kann ebenso zweckmäßig sein wie ein vollflächiges Vergießen der Platine.

Die Platine trägt auf der ersten Platinenseite elektrische Kontakte zur elektrischen Verbindung mit einem Akkupack. Die Kontakte durchragen den Boden der Aufnahmewanne.

Die Stützvorrichtung wird zweckmäßig aus einem Stützdom und einem auf dem Stützdom aufsitzenden Stützlager gebildet. Dabei kann es vorteilhaft sein, wenn das Stützlager ein zugewandtes Ende des Stützdoms übergreift.

In Weiterbildung der Erfindung ist der Betriebsschalter der Funktionseinheit mit einem Montagemodul auf der zweiten Platinenseite montiert. Das Stützlager wird am Montagemodul ausgebildet und greift in eine Durchgangsöffnung der Platine ein. Durch radiales Spiel wird gewährleistet, dass das Stützlager ohne mechanische Verbindung zur Platine ist, so dass der in das Stützlager eingreifende Stützdom ohne Berührung zur Platine ist.

Der Stützdom ist vorteilhaft in der Aufnahmewanne der Platine vorgesehen, zweckmäßig einteilig mit der Aufnahmewanne gefertigt. Bevorzugt ist die Aufnahmewanne ein Spritzgussteil aus Kunststoff.

In besonderer Ausgestaltung der Erfindung sind alle elektrischen Verbindungen zwischen dem Akkupack, der Steuereinheit und dem Betriebsschalter als Leiterbahnen auf der Platine der Steuereinheit ausgebildet. Auf diese Weise entfällt eine ansonsten notwendige Verdrahtung mit Kabelschuhen. Fehlerquellen können gesenkt werden.

Die Funktionseinheit kann ferner einen elektrischen Bremskreis für einen Elektromotor aufweisen, wobei der Bremskreis einen Bremswiderstand und einen elektrischen Bremsschalter umfasst, der auf der zweiten Platinenseite insbesondere in einem Montagemodul angeordnet ist. Der Betriebsschalter und der Bremsschalter sind zweckmäßig in einem gemeinsamen Montagemodul angeordnet, wodurch eine mechanisch feste, belastbare Anordnung der Schalter auf der Platine der Steuereinheit gegeben ist. Ein Montagemodul ist insbesondere dann zweckmäßig, wenn die Platine mit den darauf angeordneten Bauelementen vergossen werden soll. Das Montagemodul kann den Betriebsschalter vor einem Eindringen von Vergussmasse schützen.

Um auch für den Bremskreis die Verdrahtung auf ein Minimum zu reduzieren, ist vorgesehen, den Bremskreis als Leiterbahn auf der Platine der Steuereinheit auszubilden. Bevorzugt ist auch der Bremswiderstand als Leiterbahn auf der Platine vorgesehen.

Weitere Merkmale der Erfindung ergeben sich aus den weiteren Ansprüchen, der Beschreibung und der Zeichnung, in der ein nachfolgend im Einzelnen beschriebenes Ausführungsbeispiel der Erfindung dargestellt ist. Es zeigen:
- Fig. 1: in schematischer Seitenansicht ein tragbares, elektrisches Arbeitsgerät mit einem Akkupack,
- Fig. 2: eine schematische Darstellung eines elektromechanischen Funktionsmoduls zur Kontaktierung mit dem Akkupack entsprechend Fig. 1,
- Fig. 3: eine perspektivische Ansicht auf eine Platinenseite des Funktionsmoduls mit einem Betriebsschalter,
- Fig. 4: eine Aufnahmewanne zur Aufnahme einer Platine gemäß Darstellung in Fig. 3,
- Fig. 5: einen Schnitt durch das Funktionsmodul längs der Linie V-V in Fig. 2,
- Fig. 6: eine perspektivische Darstellung eines Montagemoduls zur Montage eines Betriebsschalters und/oder eines Bremsschalters,
- Fig. 7: eine perspektivische Ansicht eines als Mikroschalter ausgebildeten Betriebsschalters,
- Fig. 8: einen Schnitt durch das Funktionsmodul auf Höhe des Betriebsschalters,

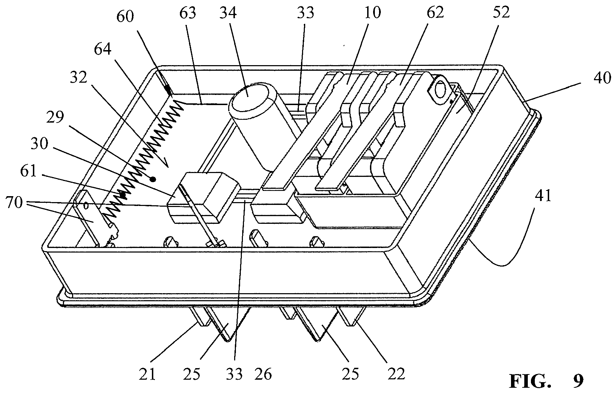

- Fig. 9: eine perspektivische Ansicht auf die zweite Platinenseite des Funktionsmoduls mit einem Betriebsschalter und einem Bremsschalter.

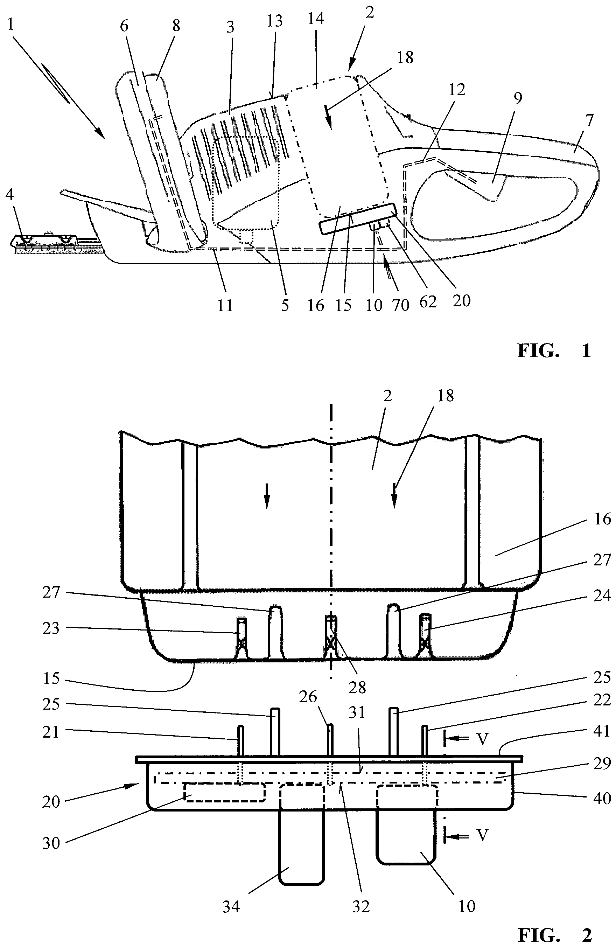

In Fig. 1 ist schematisch ein tragbares, handgeführtes Arbeitsgerät 1 am Beispiel einer Heckenschere gezeigt. Das dargestellte Arbeitsgerät kann auch als akkubetriebenes Blasgerät, akkubetriebener Freischneider, akkubetriebene Heckenschere oder dgl. akkubetriebenes Arbeitsgerät ausgeführt sein.

Das im Ausführungsbeispiel dargestellte akkubetriebene elektrische Arbeitsgerät 1 weist einen Akkupack 2 auf, der in Pfeilrichtung 18 in einen Aufnahmeschacht des Gehäuses 3 des Arbeitsgerätes 1 eingeschoben ist. Ein Werkzeug 4 des Arbeitsgerätes 1 wird von einem Elektromotor 5 angetrieben, der innerhalb des Gehäuses 3 angeordnet und gestrichelt dargestellt ist.

Das akkubetriebene Arbeitsgerät 1 weist einen vorderen Handgriff 6 und einen hinteren Handgriff 7 auf. Im gezeigten Ausführungsbeispiel ist im hinteren Handgriff 7 ein Betätigungsglied 9 für einen Betriebsschalter 10 vorgesehen, der an einem Funktionsmodul 20 gehalten ist. Im vorderen Handgriff 6 kann ein weiteres Betätigungsglied 8 vorgesehen sein, welches vorteilhaft ebenfalls auf den Betriebsschalter 10 wirkt. Zweckmäßig wirken die Betätigungsglieder 8 und 9 nach dem Prinzip einer sogenannten Zweihandschaltung auf den Betriebsschalter 10; die Wirkverbindungen 11 und 12 zwischen den Betätigungsgliedern 8 und 9 und dem Betriebsschalter 10 sind in Fig. 1 schematisch strichliert dargestellt. Wird das Betätigungsglied 9 und/oder das Betätigungsglied 8 niedergedrückt, üben die Wirkverbindungen 11 und 12 auf den Betriebsschalter 10 einen Hub in Pfeilrichtung 70 zum Einschalten des Betriebsschalters 10 aus, wie in Fig. 1 dargestellt.

Wie sich aus Fig. 1 weiter ergibt, liegt der Akkupack 2 mit einem ersten Ende 16 innerhalb des Gehäuses 3, während das andere, zweite Ende 14 des Akkupacks 2 etwa auf einer Ebene mit der Gehäuseoberseite 13 liegt.

Der eingeschobene Akkupack 2, insbesondere das erste Ende 16 des Akkupacks 2, weist eine Kontaktseite 15 auf, die dem Funktionsmodul 20 zugewandt liegt. Das Funktionsmodul 20 ist im Gehäuse 3 gehalten und weist Leistungskontakte 21 und 22 (Fig. 2) auf, die zur elektrischen Leistungsverbindung mit dem Akkupack 2 dienen. Den elektrischen Leistungskontakten 21 und 23 sind Kontaktbuchsen 23 und 24 im zugewandten Ende 16 des Akkupacks 2 zugeordnet.

Das Funktionsmodul 20 weist ferner Positionierelemente 25 auf, denen Positionieraufnahmen 27 im Ende 16 des Akkupacks 2 zugeordnet sind. Ferner ist zumindest ein Kommunikationskontakt 26 an dem Funktionsmodul 20 vorgesehen; dem Kommunikationskontakt 26 liegt eine entsprechende Kontaktbuchse 28 in der Kontaktseite 15 des Akkupacks 2 gegenüber. Die Leistungskontakte 21, 22 bilden mit den Kontaktbuchsen 23, 24 ebenso eine Steckverbindung wie der Kommunikationskontakt 26 mit der ihm zugeordneten Kontaktbuchse 28. Mit Einschieben des Akkupacks 2 in Pfeilrichtung 18 in den Geräteschacht des Gehäuses 3 werden einerseits die elektrischen Leistungskontakte 21, 22 in die Kontaktbuchsen 23 und 24 und andererseits der Kommunikationskontakt 26 in die Kontaktbuchse 28 eingeführt. Zur sicheren Ausrichtung der Kontaktbuchsen 23, 24, 28 zu den Leistungskontakten 21, 22 und dem Kommunikationskontakt 26 sind die Positionierelemente 25 vorgesehen, denen die Positionieraufnahmen 27 zugeordnet sind. Wie Fig. 2 zeigt, sind die Positionierelemente 25 länger ausgeführt als die Leistungskontakte 21, 22 bzw. der Kommunikationskontakt 26, so dass die Positionierelemente 25 als erstes mit der Kontaktseite 15 des Akkupacks 2 in Eingriff treten.

Wie in Fig. 2 schematisch dargestellt, umfasst das Funktionsmodul 20 eine Steuereinheit 30, über die der Elektromotor 5 in Betrieb genommen wird. Die Steuereinheit 30 ist auf einer Platine 29 angeordnet, die im gezeigten Ausführungsbeispiel vorzugsweise in einer Aufnahmewanne 40 liegt. Die Platine 29 weist eine erste Platinenseite 31 und eine zweite Platinenseite 32 auf.

Auf der zweiten Platinenseite 32 sind, wie die Figuren 2, 3 und 5 zeigen, der Betriebsschalter 10, die Steuereinheit 30 und Flachkontakte 70 zum Anschluss des Elektromotors 5 angeordnet. Auf der zweiten Platinenseite sind ferner weitere elektrotechnische Bauelemente 34 vorgesehen, z. B. Kondensatoren, Widerstände, Transistoren und dgl.

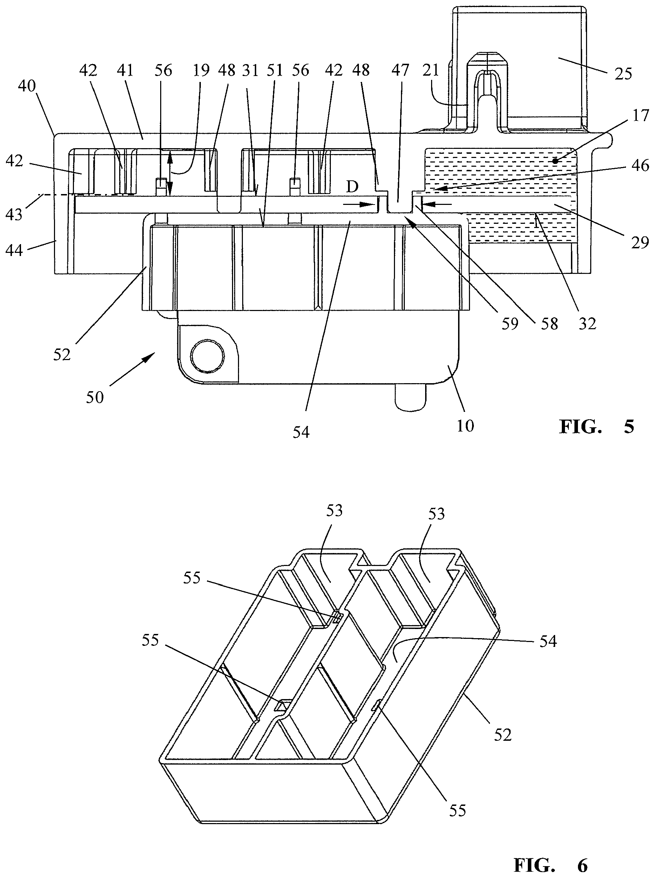

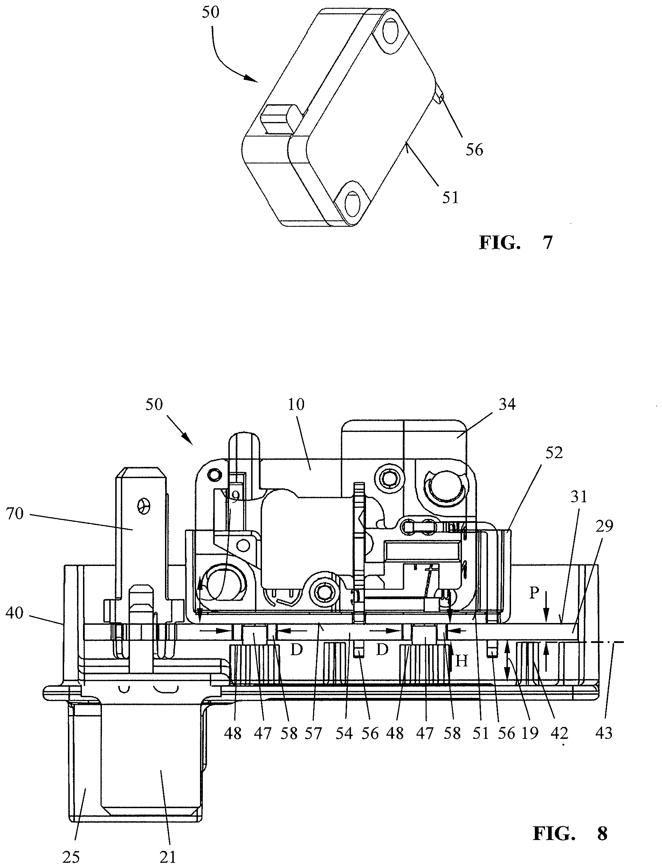

Die erste Platinenseite 31 der Platine 29 trägt die Leistungskontakte 21, 22 und den Kommunikationskontakt 26, wie Fig. 2 zeigt. Die Leistungskontakte 21 und der Kommunikationskontakt 26 dienen der elektrischen Verbindung des Funktionsmoduls 20 mit dem Akkupack 2. Ist die Platine 29 in einer Aufnahmewanne 40 angeordnet, wie in den Figuren 2 bis 5 dargestellt, durchragen die Leistungskontakte 21, 22 und der Kommunikationskontakt 26 den Boden 41 der Aufnahmewanne 40. Die Platine 29 liegt mit ihrer ersten Platinenseite dem Boden 41 der Aufnahmewanne 40 zugewandt. Die Platine 29 weist - vgl. die Figuren 5 und 8 - einen Abstand 19 zum Boden 41 der Aufnahmewanne 40 auf.

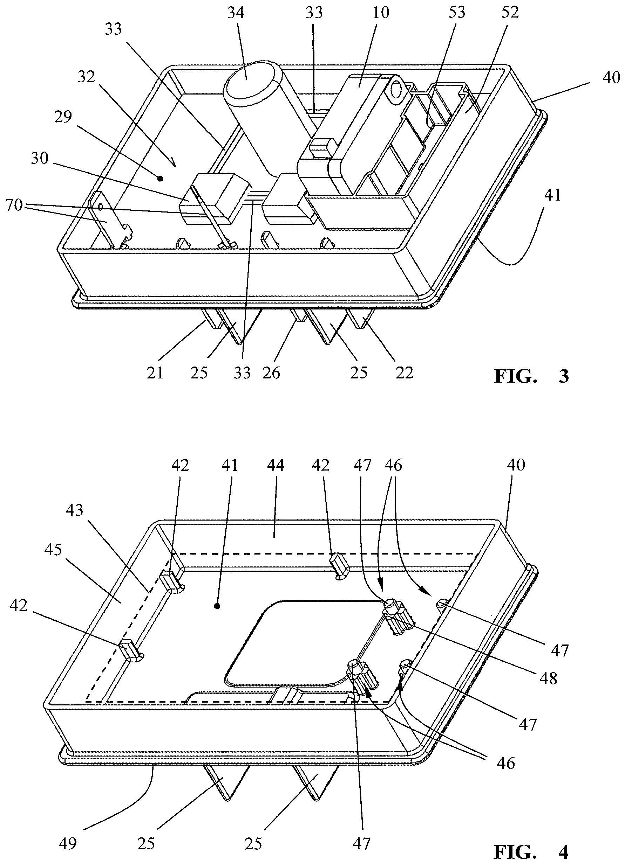

Ein besonderer Vorteil der Erfindung liegt darin, dass die Verdrahtung des Funktionsmoduls 20 ohne eine Verdrahtung mit einzelnen, separaten Verbindungsleitungen ausgeführt ist; die elektrischen Verbindungen zwischen der Steuereinheit 30, den elektrischen Leistungskontakten 21, 22, dem Kommunikationskontakt 26 und dem Betriebsschalter 10 zum Ein- und Ausschalten des Elektromotors 5 sind als Leiterbahnen 33 auf der Platine 29 ausgebildet (Fig. 3). Die Leistungskontakte 21, 22, der Kommunikationskontakt 26, die Steuereinheit 30 und der Betriebsschalter 10 sind auf der Platine 29 eingelötet.

Die in Fig. 4 dargestellte Aufnahmewanne 40 besteht vorteilhaft aus Kunststoff und weist Auflageelemente 42 auf, die vom Boden 41 der Aufnahmewanne 40 bis zu einer Auflageebene 43 ragen. Die Auflageelemente 42 sind bevorzugt an den Seitenwänden 44, 45 der Aufnahmewanne 40 gehalten und versteifen als Eckelement zwischen Boden 41 und Seitenwänden 44, 45 die Struktur der Aufnahmewanne 40.

Der Boden 41 trägt ferner Stützvorrichtungen 46. An einer Stützvorrichtung 46 kann ein Stützdom 47 ausgebildet sein. Um den Stützdom 47 herum können an der Stützvorrichtung 46 weitere Auflageelemente 48 für die Platine 29 vorgesehen sein. Die weiteren Auflageelemente 48 enden vorzugsweise an der Auflageebene 43.

Im Ausführungsbeispiel nach Fig. 4 sind insgesamt vier Stützvorrichtungen 46 vorgesehen.

Die äußeren Positionierelemente 25 bestehen aus Kunststoff und sind in der Aufnahmewanne 40 auf der dem Akkupack 2 zugewandten Außenseite 49 des Bodens 41 angebracht, insbesondere einteilig angeformt.

Wie Fig. 5 zeigt, liegt die Platine 29 mit der ersten Platinenseite 31 dem Boden 41 der Aufnahmewanne 40 zugewandt. Die Platine 29 liegt vorteilhaft in der Auflageebene 43 auf den Auflageelementen 42 und 48 auf.

Die Stützvorrichtung 46 ist zwischen dem Boden 41 der Aufnahmewanne 40 und dem Betriebsschalter 10 angeordnet, wodurch der Betriebsschalter 10 unabhängig von der Platine 29 über die Stützvorrichtung 46 statisch abgestützt ist. Die Stützvorrichtung 46 führt ohne mechanische Verbindung zur Platine 29 von der ersten Platinenseite 31 zur zweiten Platinenseite 32. Dabei ist vorgesehen, dass die Stützvorrichtung 46 eine Durchgangsöffnung D in der Platine 29 durchragt, insbesondere frei durchragt.

Der Stützdom 47 der Stützvorrichtung 46 liegt am Boden 51 des als Mikroschalter 50 ausgebildeten Betriebsschalters 10 an und stützt diesen unmittelbar gegen die Aufnahmewanne 40 ab. Unabhängig von der Relativlage des Betriebsschalters 10 zur Platine 29 und der Relativlage der Patine 29 zu den Auflagern der Auflageelemente 42 und 48 liegt der Betriebsschalter 10 auf dem freien Ende des Stützdoms 47 auf, wodurch die Toleranzkette verringert ist.

Vorteilhaft ist der als Mikroschalter 50 ausgebildete elektrische Betriebsschalter 10 in einem Montagemodul 52 gehalten, welches - in einer Ausführung für zwei Mikroschalter - in Fig. 6 dargestellt ist. Das Montagemodul 52 ist nach Art einer Gehäusewanne ausgebildet und in zwei Aufnahmeschächte 53 für zwei Mikroschalter 50 aufgeteilt. Der Boden 54 des Montagemoduls 52 weist Durchgangsöffnungen 55 für Anschlussstifte 56 (Fig. 7) des Mikroschalters 50 auf. Das Montagemodul 52 ist insbesondere zum Schutz des Mikroschalters 50 vorgesehen und kann das Eindringen von Vergussmasse 17 in das Gehäuse des Mikroschalters 50 verhindern. Das Montagemodul 52 gewährleistet auch eine mechanisch belastbare Montage des Mikroschalters 50 auf der Platine 29.

Als Betriebsschalter 10 und/oder Bremsschalter 62 können auch berührungslose Schalter wie Reed-Kontakte, Hall-Sensoren oder dgl. Annäherungsschalter verwendet werden.

Zur Montage des Mikroschalters 50 auf der Platine 29 wird der Mikroschalter 50 in einen Aufnahmeschacht 53 des Montagemoduls 52 eingeschoben, wobei die Anschlussstifte 56 die Durchgangsöffnungen 55 im Boden 54 des Montagemoduls 52 durchragen. Wie insbesondere Fig. 8 zeigt, liegt der Boden 51 des Mikroschalters 50 auf dem Boden 54 des Montagemoduls 52 auf. In dieser Lage wird das Montagemodul 52 auf die Platine 29 aufgesetzt. Die Anschlussstifte 56 durchragen dabei Lötaugen der Platine 29 und werden auf der Platine 29 angelötet.

Wie die Figuren 5 und 8 zeigen, trägt der Boden 54 des Montagemoduls 52 auf der der Platine 29 zugewandten Flachseite 57 Zylinderstutzen 58, die in zugeordnete Durchgangsöffnungen D der Platine 29 einragen. Die axiale Höhe H eines Zylinderstutzens 58 entspricht vorteilhaft etwa der Dicke P der Platine 29. Der Zylinderstutzen 58 liegt - vorzugsweise mit geringem radialen Spiel - in der Durchgangsöffnung D der Platine 29. Ein Zylinderstutzen 58 bildet ein Stützlager 59 des Montagemoduls 52, welches mit der Stützvorrichtung 46 zusammenwirkt. Das Stützlager 59 übergreift das zugewandte freie Ende des Stützdoms 47 der Stützvorrichtung 46, wodurch auch eine Ausrichtung und Fixierung des Betriebsschalters 10 in der Auflageebene 43 erzielt ist. Die in die Durchgangsöffnungen D der Platine 29 eingreifenden Zylinderstutzen 58 bestimmen auch die positionsgenaue Lage des Betriebsschalters 10 auf der Platine 29 selbst.

Der Mikroschalter 50 z. B. des Betriebsschalters 10 wird zusammen mit dem Montagemodul 52 über die Stützvorrichtung 46 am Boden 41 der Aufnahmewanne 40 abgestützt. Da die Aufnahmewanne 40 im Gehäuse 3 des Arbeitsgerätes 1 gehalten ist, ist der Mikroschalter 50 unmittelbar am Gehäuse 3 abgestützt. Durch die so erreichte kurze Toleranzkette ist gewährleistet, dass der Einschaltpunkt des Betriebsschalters 10 beim Niederdrücken eines oder beider Betätigungsglieder 8, 9 genau auf den Betätigungshub der Betätigungsglieder 8, 9 abgestimmt werden kann. Eine präzise Einstellung des Einschaltpunkts kann so gewährleistet werden.

In Weiterbildung der Erfindung ist dem über das Funktionsmodul 20 anzusteuernden Elektromotor 5 ein elektrischer Bremskreis 60 zugeordnet, wobei der Bremskreis 60 einen Bremswiderstand 61 aufweist, der vorzugsweise auf der Platine 29 der Steuereinheit 30 angeordnet ist. Ein dem Bremskreis 60 zugeordneter Bremsschalter 62 ist in dem freien Aufnahmeschacht 53 des Montagemoduls 52 eng benachbart zum Betriebsschalter 10 auf der zweiten Platinenseite 32 angeordnet. Die Ausbildung eines gemeinsamen Montagemoduls 52 für den Betriebsschalter 10 und den Bremsschalter 62 gewährleistet eine lagegenaue Montage der den Betriebsschalter 10 und den Bremsschalter 62 bildenden Mikroschalter 50. Um die Verwendung von getrennt zu verlegenden Verbindungsleitungen zu vermeiden, ist insbesondere vorgesehen, den elektrischen Bremskreis 60 als Leiterbahn 63 auf der Platine 29 auszubilden. Zweckmäßig ist auch der Bremswiderstand 61 als Leiterbahn 64 auf der Platine 29 ausgebildet.

Nach der Positionierung der bestückten Platine 29 in der Aufnahmewanne 40 und festem Andrücken des Betriebsschalters 10 an die Stützvorrichtung 46 wird die Platine 29 in der Aufnahmewanne 40 vergossen. In Fig. 5 ist die Vergussmasse 17 in schematischer Darstellung wiedergegeben. Vorteilhaft ist die Platine 29 vollflächig vergossen, also auf beiden Flachseiten 31, 32 mit Vergussmasse 17 abgedeckt. Es kann zweckmäßig sein, die Vergussmasse 17 nur partiell vorzusehen.

## Patentansprüche

1. Funktionseinheit für ein akkubetriebenes, handgeführtes Arbeitsgerät,
- mit einem Betriebsschalter (10) zur Inbetriebnahme des Arbeitsgerätes (1),
- wobei der Betriebsschalter (10) von einem Betätigungsglied (8, 9) zu betätigen ist,
- und mit einer Steuereinheit (30) zum Betrieb des Arbeitsgerätes (1),
- wobei die Steuereinheit (30) eine Platine (29) mit elektronischen Bauelementen (34) umfasst,
- und die Platine (29) der Steuereinheit (30) eine erste Platinenseite (31) und eine von der ersten Platinenseite (31) abgewandte zweite Platinenseite (32) aufweist,
**dadurch gekennzeichnet,**
- **dass** der Betriebsschalter (10) auf der zweiten Platinenseite (32) angeordnet ist,
- **dass** der Betriebsschalter (10) über eine von der Platine (29) unabhängige Stützvorrichtung (46) statisch abgestützt ist,
- wobei die Stützvorrichtung (46) ohne mechanische Verbindung zur Platine (29) eine Durchgangsöffnung (D) der Platine (29) durchragt und von der zweiten Platinenseite (32) zur ersten Platinenseite (31) führt.

2. Funktionseinheit nach Anspruch 1,
**dadurch gekennzeichnet, dass** die Platine (29) in einer Aufnahmewanne (40) gehalten ist, dass die erste Platinenseite (31) der Aufnahmewanne (40) zugewandt liegt und die Stützvorrichtung (46) den Betriebsschalter (10) gegen die Aufnahmewanne (40) abstützt.

3. Funktionseinheit nach Anspruch 2,
**dadurch gekennzeichnet, dass** die Platine (29) in der Aufnahmewanne (40) vergossen ist.

4. Funktionseinheit nach Anspruch 2,
**dadurch gekennzeichnet, dass** die Platine (29) auf der ersten Platinenseite (31) elektrische Kontakte (21, 22, 26) zur elektrischen Verbindung mit einem Akkupack (2) aufweist und die Kontakte (21, 22, 26) den Boden (41) der Aufnahmewanne (40) durchragen.

5. Funktionseinheit nach Anspruch 1,
**dadurch gekennzeichnet, dass** die Stützvorrichtung (46) aus einem Stützdom (47) und einem auf dem Stützdom (47) aufsitzenden Stützlager (59) gebildet ist.

6. Funktionseinheit nach Anspruch 5,
**dadurch gekennzeichnet, dass** das Stützlager (59) ein zugewandtes Ende des Stützdoms (47) übergreift.

7. Funktionseinheit nach Anspruch 5,
**dadurch gekennzeichnet, dass** der Betriebsschalter (10) mit einem Montagemodul (52) auf der zweiten Platinenseite (32) montiert ist, und das Stützlager (59) am Montagemodul (52) ausgebildet ist und in eine Durchgangsöffnung (D) der Platine (29) eingreift.

8. Funktionseinheit nach Anspruch 5,
**dadurch gekennzeichnet, dass** der Stützdom (46) an einer Aufnahmewanne (40) der Platine (29) ausgebildet ist.

9. Funktionseinheit nach Anspruch 1,
**dadurch gekennzeichnet, dass** alle elektrischen Verbindungen zwischen dem Akkupack (2), der Steuereinheit (30) und dem Betriebsschalter (10) als Leiterbahnen (33) auf der Platine (29) der Steuereinheit (30) ausgebildet sind.

10. Funktionseinheit nach einem der Ansprüche 1 bis 9,
**dadurch gekennzeichnet, dass** das Arbeitsgerät (1) einen Elektromotor (5) mit einem elektrischen Bremskreis (60) aufweist, und der Bremskreis (60) einen Bremswiderstand (6) und einen elektrischen Bremsschalter (62) umfasst, wobei der Bremsschalter (62) auf der zweiten Platinenseite (32) in einem Montagemodul (52) angeordnet ist.

11. Funktionseinheit nach Anspruch 10,
**dadurch gekennzeichnet, dass** der Betriebsschalter (10) und der Bremsschalter (62) in einem gemeinsamen Montagemodul (52) angeordnet sind.

12. Funktionseinheit nach Anspruch 11,
**dadurch gekennzeichnet, dass** der elektrische Bremskreis (60) als Leiterbahn (63, 64) auf einer Platine (29) der Steuereinheit (30) ausgebildet ist.

## Claims

1. Functional unit for a battery-operated hand-guided working implement,
- with an operating switch (10) for starting the working implement (1),
- wherein the operating switch (10) is designed for actuation by an actuating element (8, 9),
- and with a control unit (30) for operating the working implement (1),
- wherein the control unit (30) comprises a printed circuit board (29) with electronic components (34),
- and the printed circuit board (29) has a first circuit board side (31) facing the control unit (30) and a second circuit board side (32) averted from the first circuit board side (31),
**characterised in that**
- the operating switch (10) is located on the second circuit board side (32),
- the operating switch (10) is statically supported by a supporting device (46) independent of the printed circuit board (29),
- wherein the supporting device (46) extends through a through-opening (D) of the printed circuit board (29) without any mechanical connection to the printed circuit board (29) and extends from the second circuit board side (32) to the first circuit board side (31).

2. Functional unit according to claim 1,
**characterised in that** the printed circuit board (29) is held in a reception trough (40), **in that** the first circuit board side (31) faces the reception trough (40) and **in that** the supporting device (46) supports the operating switch (10) against the reception trough (40).

3. Functional unit according to claim 2,
**characterised in that** the printed circuit board (29) is potted in the reception trough (40).

4. Functional unit according to claim 2,
**characterised in that** the printed circuit board (29) has electric contacts (21, 22, 26) on the first circuit board side (31) for electric connection to a battery pack (2) and the contacts (21, 22, 26) extend through the base (41) of the reception trough (40).

5. Functional unit according to claim 1,
**characterised in that** the supporting device (46) is formed from a supporting dome (47) and a supporting bearing (59) seated on the supporting dome (47).

6. Functional unit according to claim 5,
**characterised in that** the supporting bearing (59) overlaps a facing end of the supporting dome (47).

7. Functional unit according to claim 5,
**characterised in that** the operating switch (10) is mounted on the second circuit board side (32) by means of a mounting module (52), and **in that** the supporting bearing (59) is formed on the mounting module (52) and engages with a through-opening (D) of the printed circuit board (29).

8. Functional unit according to claim 5,
**characterised in that** the supporting dome (47) is formed on a reception trough (40) of the printed circuit board (29).

9. Functional unit according to claim 1,
**characterised in that** all electric connections between the battery pack (2), the control unit (30) and the operating switch (10) are configured as conductor tracks (33) on the printed circuit board (29) of the control unit (30).

10. Functional unit according to any of claims 1 to 9,
**characterised in that** the working implement (1) has an electric motor (5) with an electric braking circuit (60) and the braking circuit (60) comprises a braking resistor (6) and an electric braking switch (62), the braking switch (62) being located on the second circuit board side (32) in a mounting module (52).

11. Functional unit according to claim 10,
**characterised in that** the operating switch (10) and the braking switch (62) are located in a common mounting module (52).

12. Functional unit according to claim 11,
**characterised in that** the electric braking circuit (60) is configured as a conductor track (63, 64) on a printed circuit board (29) of the control unit (30).

## Revendications

1. Unité fonctionnelle pour un appareil de travail à main alimenté par batterie,
- avec un interrupteur de service (10) pour la mise en marche de l'appareil de travail (1),
- dans lequel l'interrupteur de service (10) est à actionner par un organe d'actionnement (8, 9),
- et avec une unité de commande (30) pour faire fonctionner l'appareil de travail (1),
- dans lequel l'unité de commande (30) comprend une platine (29) avec des composants électroniques (34),
- et la platine (29) de l'unité de commande (30) comporte un premier côté de platine (31) et un deuxième côté de platine (32) opposé au premier côté de platine (31),
**caractérisée**
- **en ce que** l'interrupteur de service (10) est disposé sur le deuxième côté de platine (32),
- **en ce que** l'interrupteur de service (10) est supporté statiquement sur un dispositif de support (46) indépendant de la platine (29),
- **en ce que** le dispositif de support (46) traverse une ouverture de passage (D) de la platine (29) sans liaison mécanique avec ladite platine (29), et va du deuxième côté de platine (32) au premier côté de platine (31).

2. Unité fonctionnelle selon la revendication 1,
**caractérisée en ce que** la platine (29) est maintenue dans un bac de réception (40), **en ce que** le premier côté de platine (31) est tourné vers le bac de réception (40) et le dispositif de support (46) supporte l'interrupteur de service (10) contre le bac de réception (40).

3. Unité fonctionnelle selon la revendication 2,
**caractérisée en ce que** la platine (29) est scellée dans le bac de réception (40).

4. Unité fonctionnelle selon la revendication 2,
**caractérisée en ce que** la platine (29) comporte sur le premier côté de platine (31) des contacts électriques (21, 22, 26) pour la liaison électrique avec une batterie (2), et les contacts (21, 22, 26) traversent le fond (41) du bac de réception (40).

5. Unité fonctionnelle selon la revendication 1,
**caractérisée en ce que** le dispositif de support (46) se compose d'un dôme de support (47) et d'un palier de support (59) posé sur le dôme de support (47).

6. Unité fonctionnelle selon la revendication 5,
**caractérisée en ce que** le palier de support (59) couvre une extrémité du dôme de support (47) tournée vers lui.

7. Unité fonctionnelle selon la revendication 5,
**caractérisée en ce que** l'interrupteur de service (10) est monté avec un module de montage (52) sur le deuxième côté de platine (32), et le palier de support (59) est formé sur le module de montage (52) et pénètre dans une ouverture de passage (D) de la platine (29).

8. Unité fonctionnelle selon la revendication 5,
**caractérisée en ce que** le dôme de support (46) est formé sur un bac de réception (40) de la platine (29).

9. Unité fonctionnelle selon la revendication 1,
**caractérisée en ce que** toutes les liaisons électriques entre la batterie (2), l'unité de commande (30) et l'interrupteur de service (10) sont formées comme des pistes conductrices (33) sur la platine (29) de l'unité de commande (30).

10. Unité fonctionnelle selon l'une des revendications 1 à 9,
**caractérisée en ce que** l'appareil de travail (1) comporte un moteur électrique (5) avec un circuit de frein électrique (60), et le circuit de frein électrique (60) comprend une résistance de frein (6) et un interrupteur de frein électrique (62), dans lequel l'interrupteur de frein (62) est disposé sur le deuxième côté de platine (32) dans un module de montage (52).

11. Unité fonctionnelle selon la revendication 10,
**caractérisée en ce que** l'interrupteur de service (10) et l'interrupteur de frein (62) sont disposés dans un module de montage commun (52).

12. Unité fonctionnelle selon la revendication 11,
**caractérisée en ce que** le circuit de frein électrique (60) est formé comme une piste conductrice (63, 64) sur une platine (29) de l'unité de commande (30).
